# EUROPÄISCHE PATENTSCHRIFT

(11) **EP 3 574 516 B1**
(45) Veröffentlichungstag und Bekanntmachung des Hinweises auf die Patenterteilung: **28.10.2020**
(21) Anmeldenummer: 18701747.0
(22) Anmeldetag: 25.01.2018
(51) Int. Cl.: H01H 9/54, H02H 7/22, H03K 17/28

(54) **NIEDERSPANNUNGS-SCHUTZSCHALTGERÄT**
LOW-VOLTAGE CIRCUIT BREAKER DEVICE
DISJONCTEUR BASSE TENSION

(30) Priorität: 25.01.2017 DE 102017101452
(43) Veröffentlichungstag der Anmeldung: 04.12.2019
(73) Patentinhaber: Eaton Intelligent Power Limited, Dublin 4 (IE)
(72) Erfinder: ASKAN, Kenan, 1090 Wien (AT)
(74) Vertreter: Eaton IP Group EMEA
(86) Internationale Anmeldenummer: PCT/EP2018/051766
(87) Internationale Veröffentlichungsnummer: WO 2018/138175

(56) Entgegenhaltungen:
- WO-A1-2015/028634
- US-A1- 2003 180 997
- DATABASE WPI Week 201706 Thomson Scientific, London, GB; AN 2017-01761W XP002780108, -& CN 205 847 212 U (SINA NEWCHANCE NEW ENERGY TECHNOLOGY CO) 28. Dezember 2016 (2016-12-28)

## Beschreibung

Die Erfindung betrifft ein Niederspannungs-Schutzschaltgerät gemäß dem Oberbegriff des Patentanspruches 1.

Es ist ein entsprechendes Schutzschaltgerät aus der WO 2015/028634 A1 der Anmelderin bekannt. Beim Ausschalten des Schutzschaltgeräts wird dabei erst der Bypassschalter geöffnet, wobei ein Lichtbogen entsteht, und der Strom auf die Halbleiterschaltungsanordnung kommutiert. Nachfolgend wird die, zuvor eingeschaltete, Halbleiterschaltungsanordnung ausgeschaltet und die Trennkontakte zum Bereiststellen der galvanischen Trennung, welche Trennkontakte in Serie zum Bypassschalter geschaltet sind, werden geöffnet.

Für das Abschalten eines Kurzschlussstromes ist es wichtig, dass die Kontakte des Bypassschalters so weit geöffnet sind, dass es bei einem Abschalten des Kurzschlussstromes nicht zu einem erneuten Zünden eines Lichtbogens an den Kontakten des Bypassschalters kommt. Gleichzeitig soll der Kurzschlussstrom jedoch so schnell wie möglich abgeschaltet werden, um das nachgeschaltete Netz aber auch die Halbleiterschaltungsanordnung gering zu belasten. Durch ein frühes bzw. schnelles Abschalten kann der Kurzschlussstrom zudem noch in der Phase des Anstieges abgeschaltet werden, noch bevor dieser seine, durch den Innenwiderstand des Versorgungsnetzes, sowie den Widerstand das nachgeschalteten Netzes bedingte, maximale Amplitude erreicht, wodurch die Belastung von Netz und Geräten weiter gering gehalten werden kann.

Es ist bekannt, den Bypassschalter elektrisch bzw. elektromagnetisch anzusteuern, damit sich dessen Kontakte öffnen. Gleichzeitig wird ein Timer gestartet. Dabei wird davon ausgegangen, dass nach einer gewissen Zeitspanne die Kontakte des Bypassschalters weit genug geöffnet sind, um den Kurzschlussstrom sicher abschalten zu können, und einen ausreichend stabilen bzw. statischen Zustand eingenommen haben. Diese Zeitspanne muss mit Sicherheitsfaktoren versehen sein, um sicherzustellen, dass die Kontakte des Bypassschalters auch tatsächlich weit genug geöffnet sind. Diese Sicherheitsfaktoren sind, aufgrund erheblicher Streuungen des Öffnungsverhaltens mechanischer Schalter, sowohl notwendig als auch entsprechend ausreichend zu bemessen. Dadurch kommt es zu einem späten Abschalten des Kurzschlussstroms und einer entsprechend hohen Belastung des Netzes und der Halbleiterschaltungsanordnung.

Die Dokumente US 2003/180997 A1 bzw. CN 205 847 212 U beschreiben jeweils eine Halbleiteranordnung, in welcher eine millereffektbedingte Spannungsspitze detektiert wird.

Aufgabe der Erfindung ist es daher ein Niederspannungs-Schutzschaltgerät der eingangs genannten Art anzugeben, mit welcher die genannten Nachteile vermieden werden können, mit welchem die Kurzschlussbelastung für das Niederspannungs-Schutzschaltgerät selbst, sowie das zu schützende elektrische Netz gering gehalten werden kann.

Erfindungsgemäß wird dies durch die Merkmale des Patentanspruches 1 erreicht.

Dadurch kann der Zeitpunkt an dem sich die Kontakte des Bypassschalters tatsächlich zu öffnen beginnen sehr genau erfasst werden, und zur Steuerung der Halbleiterschaltungsanordnung verwendet werden.

Bei der gegenständlichen Erfindung wird der Einfluss der Lichtbogenspannung auf den sog. Miller-Effekt ausgenützt, um zu detektieren, ob das Bypassrelais unter den Bedingungen eines elektrischen Fehlers geöffnet hat oder nicht. Beim Öffnen des Bypassschalters 8 kommt es zu Bildung eines Lichtbogens, wobei die Spannung an den Kontakten sehr schnell auf die Lichtbogenspannung ansteigt. Die Slew Rate kann dabei einige hundert Volt pro Mikrosekunde betragen. Der Leistungshalbleiter ist dabei bereits eingeschaltet. Bei Ausbildung des Leistungshalbleiters als IGBT verursacht diese Spannungsänderung eine Umladung der Gate-Kollektor-Kapazität, was zu einem deutlich wahrnehmbaren anstieg der Gate-Spannung führt. Dieser Anstieg kann ausgenützt werden, um zu detektieren, ob sich die Kontakte des Bypassschalters zum Öffnen bewegt haben.

Der Bypassschalter ist ein mechanischer Schalter. Das Öffnen der mechanischen Kontakte dieses Schalters erfolgt niemals exakt gleich zu einem vorherigen Öffnen desselben Bypassschalters oder eines anderen gleichartigen Bypassschalters. Dieses Verhalten muss bei herkömmlichen Niederspannungs-Schutzschaltgeräten durch entsprechende Sicherheiten berücksichtigt werden. Es hat sich gezeigt, dass beim Öffnungsvorgang insbesondere die Anfangsphase der Kontaktöffnung, daher die Zeitspanne vom elektrischen Ansteuern des Bypassschalters bis dem Zeitpunkt an dem ein tatsächliches Öffnen der Kontakte beginnt, daher eine erste Bewegung der beweglichen Kontakte tatsächlich erfolgt, die Phase des gesamten Schaltvorganges des Bypassschalters ist, welche die größte zeitliche Streuung verursacht. Die nachfolgende Phase der Kontaktöffnung, in der sich die beweglichen Kontakte bereits in Bewegung befinden und lediglich den weiteren Öffnungsweg zurücklegen müssen, hat sich hingegen als relativ konstant erwiesen.

Durch die gegenständlichen Maßnahmen kann der Zeitpunkt an dem die tatsächliche Kontaktöffnung beim Bypassschalter erfolgt detektiert werden, und als Startpunkt für einen Timer dienen, der nunmehr ausgehend von diesem Zeitpunkt eine sehr genau bekannte Zeitspanne bis zu einem vollständigen Öffnen der Kontakte zählen kann. Dieser Timer kann mit wesentlich geringeren zeitlichen Sicherheiten arbeiten. Dadurch kann der Kurzschlussstrom zu einem Zeitpunkt abgeschaltet werden, an dem dies technisch möglich ist, ohne das Netz und die Halbleiterschaltungsanordnung weiterer Belastung durch den Kurzschlussstrom auszusetzen.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 ein erstes Schutzschaltgerät gemäß dem Stand der Technik;
Fig. 2 eine erste Ausführungsform einer Schaltungsanordnung eines gegenständlichen Niederspannungs-Schutzschaltgeräts; und
Fig. 3 eine zweite Ausführungsform einer Schaltungsanordnung eines gegenständlichen Niederspannungs-Schutzschaltgeräts.

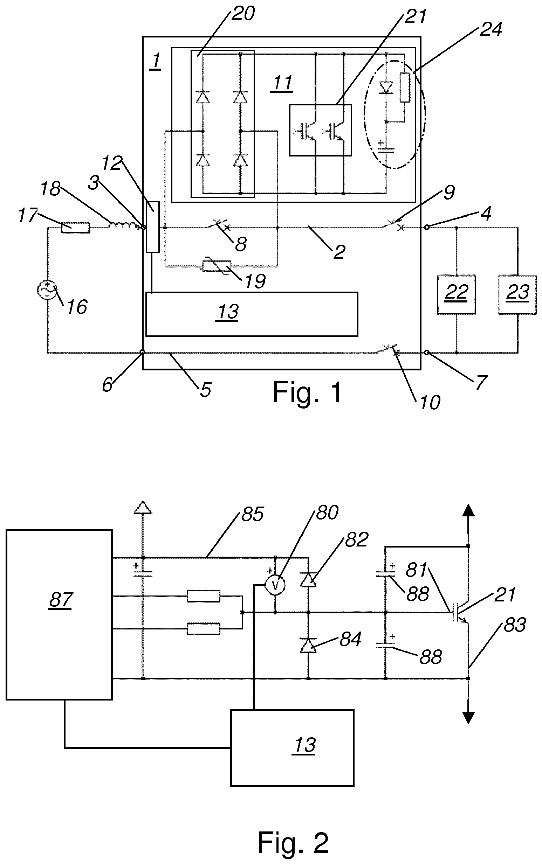

Fig. 1 zeigt eine bevorzugte Ausführung eines Niederspannungs-Schutzschaltgeräts 1 mit mindestens einer Außenleiterstrecke 2 von einem Außenleiterversorgungsanschluss 3 des Niederspannungs-Schutzschaltgeräts 1 zu einem Außenleiterlastanschluss 4 des Niederspannungs-Schutzschaltgeräts 1, und einer Neutralleiterstrecke 5 von einem Neutralleiteranschluss 6 des Niederspannungs-Schutzschaltgeräts 1 zu einem Neutralleiterlastanschluss 7 des Niederspannungs-Schutzschaltgeräts 1, wobei in der Außenleiterstrecke 2 ein mechanischer Bypassschalter 8 angeordnet ist, wobei eine Halbleiterschaltungsanordnung 11 des Niederspannungs-Schutzschaltgeräts 1 parallel zum Bypassschalter 8 geschaltet ist, wobei die Halbleiterschaltungsanordnung 11 wenigstens einen Leistungshalbleiter 21, insbesondere einen IGBT, mit einem Steueranschluss, insbesondere einem Gate-Anschluss, aufweist, wobei in der Außenleiterstrecke 2 eine Strommessanordnung 12 angeordnet ist, welche mit einer elektronischen Steuereinheit 13 des Schutzschaltgeräts 1 verbunden ist, wobei die elektronische Steuereinheit 13 dazu ausgebildet ist, den Bypassschalter 8 und die Halbleiterschaltungsanordnung 11 bei Detektion eines vorgebbaren Überstromes, insbesondere eines Kurzschlussstromes, durch die Strommessanordnung 12 anzusteuern.

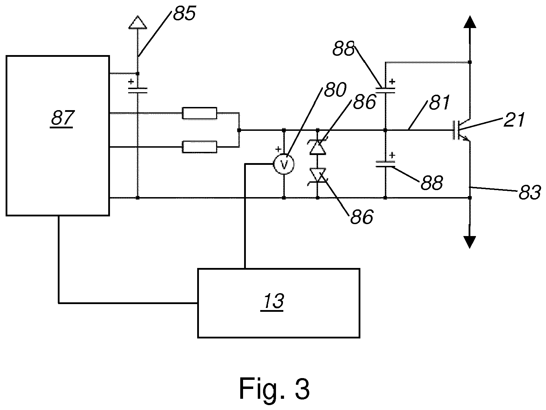

Die Fig. 2 und 3 zeigen jeweils unterschiedliche Ausführungsformen einer Schaltungsanordnung eines Niederspannungs-Schutzschaltgeräts 1 mit wenigstens einer Spannungsmessungsanordnung 80 zur Detektion einer millereffektbedingten Spannungsspitze, daher einer Spannungsspitze bzw. Spannungserhöhung aufgrund des sog. Millereffekts, an dem wenigstens einen Leistungshalbleiter 21 der ersten Halbleiterschaltungsanordnung 11. Die betreffende Spannungsspitze wird daher an dem Leistungshalbleiter 21 bzw. dessen, insbesondere parasitären, Kapazitäten erzeugt, kann jedoch an jeder Stelle des Niederspannungs-Schutzschaltgeräts 1 aufgenommen werden, an der diese nachweisbar ist.

Dadurch kann der Zeitpunkt an dem sich die Kontakte des Bypassschalters 8 tatsächlich zu öffnen beginnen sehr genau erfasst werden, und zur Steuerung der Halbleiterschaltungsanordnung 11 verwendet werden.

Beim Öffnen des Bypassschalters 8 kommt es zu Bildung eines Lichtbogens. Als Folge der Potenzialdifferenz am Lichtbogen kommt es zu einem Stromfluss. Aufgrund des sog. Millereffekts kommt es beim ersten Stromfluss über den Leistungshalbleiter21, welcher insbesondere ein IGBT oder ein MOSFET ist, zu einer deutlichen, und sehr kurzen Spannungsspitze. Da der erste Stromfluss über den Leistungshalbleiter 21 als Folge des Lichtbogens mit dem Beginn des Öffnens der Kontakte des Bypassschalters 8 einsetzt, fällt das Auftreten besagter Spannungsspitze mit dem tatsächlichen Beginn des Öffnens des Bypassschalters 8 zusammen.

Der Bypassschalter 8 ist ein mechanischer Schalter. Das Öffnen der mechanischen Kontakte dieses Schalters erfolgt niemals exakt gleich zu einem vorherigen Öffnen desselben Bypassschalters 8 oder eines anderen gleichartigen Bypassschalters 8. Dieses Verhalten muss bei herkömmlichen Niederspannungs-Schutzschaltgeräten 1 durch entsprechende Sicherheiten berücksichtigt werden. Es hat sich gezeigt, dass beim Öffnungsvorgang insbesondere die Anfangsphase der Kontaktöffnung, daher die Zeitspanne vom elektrischen Ansteuern des Bypassschalters 8 bis dem Zeitpunkt an dem ein tatsächliches Öffnen der Kontakte beginnt, daher eine erste Bewegung der beweglichen Kontakte tatsächlich erfolgt, die Phase des gesamten Schaltvorganges des Bypassschalters 8 ist, welche die größte zeitliche Streuung verursacht. Die nachfolgende Phase der Kontaktöffnung, in der sich die beweglichen Kontakte bereits in Bewegung befinden und lediglich den weiteren Öffnungsweg zurücklegen müssen, hat sich hingegen als relativ konstant erwiesen.

Durch die gegenständlichen Maßnahmen kann der Zeitpunkt an dem die tatsächliche Kontaktöffnung beim Bypassschalter 8 erfolgt detektiert werden, und als Startpunkt für einen Timer dienen, der nunmehr ausgehend von diesem Zeitpunkt eine sehr genau bekannte Zeitspanne bis zu einem vollständigen Öffnen der Kontakte zählen kann. Dieser Timer kann mit geringen zeitlichen Sicherheiten arbeiten. Dadurch kann der Kurzschlussstrom zu einem Zeitpunkt abgeschaltet werden, an dem dies technisch möglich ist, ohne das Netz und die Halbleiterschaltungsanordnung 11 weiterer Belastung durch den Kurzschlussstrom auszusetzen.

Durch das schnellere Abschalten eines Kurzschlusses können weiters in der Halbleiterschaltungsanordnung 11 geringer maximal-belastbare Leistungshalbleiter 20, 21 vewendet werden. Derartige Leistungshalbleiter 20, 21 weisen sowohl einen geringeren Innenwiderstand, als auch eine geringere physische Baugröße auf, als höher belastbare Leistungshalbleiter 20, 21. Durch die geringere Baugröße, insbesondere die kürzeren Wege innerhalb der Leistungshalbleiter 21 kann die relevante Schleifeninduktanz des Niederspannungs-Schutzschaltgeräts 1 verringert werden, wodurch weiters direkt die Kommutierungszeit des Kurzschlussstromes auf die Halbleiterschaltungsanordnung 11 verringert werden kann. Durch den geringeren Innenwiderstand wird die Kommutierungszeit weiters verringert.

Durch das schnelle Abschalten eines Kurzschluss- bzw- Überlaststromes wird weniger Energie als sonst in Form von Streuinduktivitäten bzw. in der Netzinduktanz gespeichert, wodurch der Überspannungsableiter 19 sowie der Snubber 24 geschont wird. Dieser kann auch kleiner dimensioniert werden.

Bei dem gegenständlichen Niederspannungs-Schutzschaltgerät 1 wie auch dem Schutzschaltgerät gemäß der WO 2015/028634 A1 handelt es sich um Niederspannungs-Schutzschaltgeräte. Als Niederspannung wird wie an sich üblich der Bereich bis 1000V Wechselspannung bzw. 1500V Gleichspannung bezeichnet.

Fig. 1 zeigt ein Schutzschaltgerät gemäß dem Stand der Technik, wie dieses etwa in der WO 2015/028634 A1 beschrieben ist. Dieses weist eine Außenleiterstrecke 2 sowie eine Neutralleiterstrecke 5 auf. Die Außenleiterstrecke 2 verläuft durch das Schutzschaltgerät 1 von einem Außenleiterversorgungsanschluss 3 zu einem Außenleiterlastanschluss 4. Die Neutralleiterstrecke 5 verläuft durch das Schutzschaltgerät 1 von einem Neutralleiteranschluss 6 zu einem Neutralleiterlastanschluss 7. Die betreffenden Anschlüsse 3, 4, 6, 7 sind jeweils bevorzugt als Schraubanschlussklemmen bzw. Steckanschlussklemmen ausgebildet, und in dem Schutzschaltgerät 1 von außen zugänglich angeordnet.

Das Schutzschaltgerät 1 weist bevorzugt ein Isolierstoffgehäuse auf. In der Außenleiterstrecke 2 ist ein mechanischer Bypassschalter 8 angeordnet. Weiters ist parallel zum Bypassschalter 8 ein Überspannungsableiter 19 geschaltet.

In der Außenleiterstrecke 2 ist weiters ein erster mechanischer Trennschalter 9 seriell zum Bypassschalter 8 angeordnet. In der Neutralleiterstrecke 5 ist ein zweiter mechanischer Trennschalter 10 angeordnet. Parallel zum Bypassschalter 8 ist eine Halbleiterschaltungsanordnung 11 geschaltet.

Das Schutzschaltgerät 1 weist weiters eine Strommessanordnung 12 auf, welche in der Außenleiterstrecke 2 angeordnet ist, und welche bevorzugt umfassend einem Shunt-Widerstand ausgebildet ist.

Die Strommessanordnung 12 ist mit einer elektronischen Steuereinheit 13 des Schutzschaltgeräts 1 verbunden, welche bevorzugt umfassend einen Mikrocontroller bzw. Mikroprozessor ausgebildet ist. Die elektronische Steuereinheit 13 ist dazu ausgebildet, den Bypassschalter 8 und die erste Halbleiterschaltungsanordnung 11, sowie den ersten mechanischen Trennschalter 9 und den zweiten mechanischen Trennschalter 10, anzusteuern, daher diese vorgebbar zu betätigen bzw. zu schalten. Hiezu ist die elektronische Steuereinheit 13 mit der Halbleiterschaltungsanordnung 11, sowie weiters mit, insbesondere elektromagnetischen, Betätigungselementen der mechanischen Schalter, daher des Bypassschalters 8, des ersten mechanischen Trennschalters 9 und des zweiten mechanischen Trennschalters 10 bevorzugt schaltungstechnisch verbunden. Die entsprechenden Verbindungen ausgehend von der elektronischen Steuereinheit 13 sind nicht dargestellt.

Die Halbleiterschaltungsanordnung 11 weist bevorzugt eine Gleichrichterschaltung 20, welche bevorzugt als Vollbrücke ausgebildet ist, sowie, bei der gegenständlichen Ausführungsform zwei Leistungshalbleiter 21, welche gegenständlich als IGBT ausgebildet sind, als eigentliche Schalt- bzw. Regelelemente auf. Dabei kann auch ein einzelner größerer Leistungshalbleiter 21 vorgesehen sein.

In Fig. 1 ist neben dem eigentlichen Schutzschaltgerät 1 weites die elektrische Umgebung angedeutet. Dabei ist das Versorgungsnetz durch die AC/DC-Netzspannungsquelle 16, den Netzinnenwiderstand 17 und die Netzinduktivität 18 dargestellt. Weiters ist eine elektrische Last 23, sowie ein elektrischer Fehler 22 in Form eines Kurzschlusses dargestellt.

Beim einem Schaltgerät gemäß Fig. 1 ist vorgesehen, dass ein Abschaltvorgang von dem Bypassschalter 8 und der Halbleiterschaltungsanordnung 11 durchgeführt wird, und die ersten und zweiten Trennschalter 9, 10 lediglich dazu dienen, nach erfolgter Abschaltung eine galvanische Trennung des Lastkreises sicherzustellen.

Ein gegenständliches Niederspannungs-Schutzschaltgerät 1 entspricht bevorzugt bis auf die weiteren Merkmale, wie diese etwa in den Fig. 2 und 3 dargestellt sind, einem Niederspannungs-Schutzschaltgerät gemäß Fig. 1. Bei zweipoligen Ausführungen eines gegenständlichen Niederspannungs-Schutzschaltgeräts 1 ist die als Neutralleiterstrecke 5 bezeichnete Schaltstrecke bzw. schaltungstechnische Verbindung durch das Niederspannungs-Schutzschaltgeräts 1 entsprechend der beschriebenen Außenleiterstrecke 2 ausgebildet bzw. auszubilden.

Es ist vorgesehen, dass das Niederspannungs-Schutzschaltgerät 1 wenigstens eine Spannungsmessungsanordnung 80 zur Detektion einer millereffektbedingten Spannungsspitze an dem wenigstens einen Leistungshalbleiter 21 der ersten Halbleiterschaltungsanordnung 11 aufweist.

Dabei kann vorgesehen sein, dass die Spannungsmessungsanordnung 80 zum Messen einer Steueranschluss-Spannung an dem wenigstens einen Leistungshalbleiter 21 ausgebildet bzw. entsprechend in dem Niederspannungs-Schutzschaltgerät 1 angeordnet ist. Bei der bevorzugten Ausbildung des Leistungshalbleiters 21 als IGBT handelt es sich bei dem Steueranschluss um den sog. Gate-Anschluss. Dabei ist vorgesehen die Gate-Spannung zu messen. Bei Ausbildung des Leistungshalbleiters 21 MOSFET würde als Steueranschluss-Spannung ebenfalls die sog. Gate-Spannung gemessen.

Die Spannungsmessungsanordnung 80 ist bevorzugt mit der elektronischen Steuereinheit 13 verbunden.

Wie bereits dargelegt dient die Spannungsmessungsanordnung 80 dazu eine Spannungsspitze, welche aufgrund des Millereffekts entsteht, zu detektieren. Die Steuereinheit 13 und/oder die Spannungsmessungsanordnung 80 sind entsprechend bevorzugt dazu ausgebildet, eine - nach Ausgabe eines Bypassschalter-Öffnungssignals - auftretende vorgebbare Spannungsspitze zu detektieren. In diesem Zusammenhang ist bevorzugt vorgesehen, dass die Spannungsmessungsanordnung 80 eine entsprechend hohe Zeitauflösung aufweist, um einen Peak zu detektieren. Bei der bevorzugt digitalen Ausbildung der Steuereinheit 13 bzw. der Spannungsmessungsanordnung 80 ist bevorzugt vorgesehen, dass ein aufgenommenes analoges Spannungssignal mit einer Abtastrate von wenigstens 20 kHz, vorzugsweise 40 kHz, digital erfasst wird.

Da die zu detektierende Spannungsspitze nur zu einem ganz bestimmten Zeitpunkt auftritt bzw. erwartet und ausgewertet wird, nämlich nachdem der Bypassschalter 8 dazu angesteuert wurde die Kontakte zu öffnen, kann vorgesehen sein, dass die Spannungsmessungsanordnung 80 lediglich während dieses Vorgangs in Betrieb ist, und die Steuereinheit 13 entsprechend ausgebildet ist. Dadurch kann die Leistungsaufnahme und die Eigenerwärmung des Niederspannungs-Schutzschaltgeräts 1 gering gehalten werden.

Allerdings hat es sich für den gesamten Betrieb des Niederspannungs-Schutzschaltgeräts 1 als vorteilhaft erwiesen, dass die Spannungsmessungsanordnung 80 die entsprechende Spannung im Wesentlich permanent überwacht. Dadurch kann die Steuereinheit 13 die Funktion des Leistungshalbleiters 21 dahin gehend überwachen, ob dieser eingeschaltet ist oder funktioniert.

Bevorzugt ist vorgesehen, dass die Steuereinheit 13 einen Timer aufweist, welcher mit Detektion der Spannungsspitze gestartet wird, und dass die Steuereinheit 13 dazu ausgebildet ist, nach Ablauf des Timers ein Abschaltsignal an die erste Halbleiterschaltungsanordnung 11 auszugeben. Dadurch kann die Zeit zum Abschalten eines Kurzschlussstromes verringert werden, wie bereits ausgeführt.

Es kann weiters vorgesehen sein, dass die Steuereinheit 13 eine Vergleichs- bzw. Analyseeinheit aufweist, welche dazu ausgebildet ist, eine aufgenommene Spannungsspitze dahin gehend zu untersuchen, ob es sich tatsächlich um eine vorgebbare bzw. erwartete Spannungsspitze aufgrund des Millereffekts handelt. Dabei können Verfahren angewendet bzw. abgewandelt werden, welche aus dem Bereich der Lichtbogendetektoren bekannt sind.

Fig. 2 zeigt eine erste Ausführungsform einer Schaltungsanordnung eines gegenständlichen Niederspannungs-Schutzschaltgeräts 1. Dabei ist vorgesehen, dass eine erste Bypassdiode 82 zwischen dem Steueranschluss 81 des Leistungshalbleiters 21 und einem Versorgungsspannungsanschluss 85 geschalten ist, und dass eine zweite Bypassdiode 84 zwischen dem Steueranschluss 81 des Leistungshalbleiters 21 und einem Masseanschluss 83 des Leistungshalbleiters 21 geschalten ist. Die Bypassdioden 82, 84 dienen dabei in erster Linie dem Schutz des Leistungshalbleiters 21. Die erste Bypassdiode 82 ermöglicht weiters auch die Abnahme einer Spannung, an welcher ebenfalls eine entsprechende Spannungsspitze als Folge der Wirkung des Millereffekts detektierbar ist, weshalb bevorzugt vorgesehen ist, dass die Spannungsmessungsanordnung 80 schaltungstechnisch parallel zur ersten Bypassdiode 82 angeordnet ist.

Die Schaltungsanordnung gemäß Fig. 2 und 3 weist weiters zwei Kondensatoren 88 auf, um gegebenenfalls den Millereffekt zu vergrößern, und so eine deutlicher detektierbare Spannungsspitze zu verursachen. Bei den beiden Kondensatoren 88 kann es sich aber auch um rein parasitäre Kapazitäten handeln.

Fig. 3 zeigt eine zweite Ausführungsform einer Schaltungsanordnung eines gegenständlichen Niederspannungs-Schutzschaltgeräts 1. Bei der Ausführungsform gemäß Fig. 3 wird die Steueranschluss-Spannung, insbesondere die Gate-Spannung, an dem wenigstens einen Leistungshalbleiter 21 der Halbleiterschaltungsanordnung 11 gemessen.

Bei der Ausführungsform gemäß Fig. 3 sind zwischen dem Steueranschluss 81 des Leistungshalbleiters 21 und einem Masseanschluss 83 des Leistungshalbleiters 21 zwei antiseriell angeordnete Zenerdioden 86 geschaltet, welche ebenfalls in erster Linie dem Schutz des Leistungshalbleiters 21 dienen. Schaltungstechnisch parallel zu den beiden Zenerdioden 86 ist die Spannungsmessungsanordnung 80 angeordnet.

## Patentansprüche

1. Niederspannungs-Schutzschaltgerät (1) mit mindestens einer Außenleiterstrecke (2) von einem Außenleiterversorgungsanschluss (3) des Niederspannungs-Schutzschaltgeräts (1) zu einem Außenleiterlastanschluss (4) des Niederspannungs-Schutzschaltgeräts (1), und einer Neutralleiterstrecke (5) von einem Neutralleiteranschluss (6) des Niederspannungs-Schutzschaltgeräts (1) zu einem Neutralleiterlastanschluss (7) des Niederspannungs-Schutzschaltgeräts (1), wobei in der Außenleiterstrecke (2) ein mechanischer Bypassschalter (8) angeordnet ist, wobei eine erste Halbleiterschaltungsanordnung (11) des Niederspannungs-Schutzschaltgeräts (1) parallel zum Bypassschalter (8) geschaltet ist, wobei die erste Halbleiterschaltungsanordnung (11) wenigstens einen Leistungshalbleiter (21), insbesondere einen IGBT, mit einem Steueranschluss, insbesondere einem Gate-Anschluss, aufweist, wobei in der Außenleiterstrecke (2) eine Strommessanordnung (12) angeordnet ist, welche mit einer elektronischen Steuereinheit (13) des Schutzschaltgeräts (1) verbunden ist, wobei die elektronische Steuereinheit (13) dazu ausgebildet ist, den Bypassschalter (8) und die erste Halbleiterschaltungsanordnung (11) bei Detektion eines vorgebbaren Überstromes, insbesondere eines Kurzschlussstromes, durch die Strommessanordnung (12) anzusteuern, **dadurch gekennzeichnet, dass** das Niederspannungs-Schutzschaltgerät (1) wenigstens eine Spannungsmessungsanordnung (80) zur Detektion einer millereffektbedingten Spannungsspitze an dem wenigstens einen Leistungshalbleiter (21) der ersten Halbleiterschaltungsanordnung (11) aufweist, dass die Spannungsmessungsanordnung (80) mit der elektronischen Steuereinheit (13) verbunden ist, dass die Steuereinheit (13) und/oder die Spannungsmessungsanordnung (80) dazu ausgebildet ist, eine - nach Ausgabe eines Bypassschalter-Öffnungssignals - auftretende vorgebbare Spannungsspitze zu detektieren, dass die Steuereinheit (13) einen Timer aufweist, welcher mit Detektion der Spannungsspitze gestartet wird, und dass die Steuereinheit (13) dazu ausgebildet ist, nach Ablauf des Timers ein Abschaltsignal an die erste Halbleiterschaltungsanordnung (11) auszugeben.

2. Niederspannungs-Schutzschaltgerät (1) nach Anspruch 1, **dadurch gekennzeichnet, dass** eine erste Bypassdiode (82) zwischen dem Steueranschluss (81) des Leistungshalbleiters (21) und einem Versorgungsspannungsanschluss (85) geschalten ist.

3. Niederspannungs-Schutzschaltgerät (1) nach Anspruch 2, **dadurch gekennzeichnet, dass** die Spannungsmessungsanordnung (80) schaltungstechnisch parallel zur ersten Bypassdiode (82) angeordnet ist.

4. Niederspannungs-Schutzschaltgerät (1) nach einem der Ansprüche 1 bis 3, **dadurch gekennzeichnet, dass** zwischen dem Steueranschluss (81) des Leistungshalbleiters (21) und einem Masseanschluss (83) des Leistungshalbleiters (21) zwei antiseriell angeordnete Zenerdioden (86) geschaltet sind.

5. Niederspannungs-Schutzschaltgerät (1) nach Anspruch 4, **dadurch gekennzeichnet, dass** die Spannungsmessungsanordnung (80) schaltungstechnisch parallel zu den beiden Zenerdioden (86) angeordnet ist.

6. Niederspannungs-Schutzschaltgerät (1) nach einem der Ansprüche 1 bis 5, **dadurch gekennzeichnet, dass** parallel zum wenigstens einen Leistungshalbleiter (21) ein Snubber (24) geschaltet ist.

## Claims

1. Low-voltage protective switching device (1) having at least one outer conductor path (2) from an outer conductor supply connection (3) of the low-voltage protective switching device (1) to an outer conductor load connection (4) of the low-voltage protective switching device (1), and one neutral conductor path (5) from the neutral conductor connection (6) of the low-voltage protective switching device (1) to a neutral conductor load connection (7) of the low-voltage protective switching device (1), wherein a mechanical bypass switch (8) is arranged in the outer conductor path (2), wherein a first semiconductor circuit arrangement (11) of the low-voltage protective switching device (1) is connected in parallel to the bypass switch (8), wherein the first semiconductor circuit arrangement (11) has at least one power semiconductor (21), in particular an IGBT, with a control connection, in particular a gate-connection, wherein in the outer conductor path (2) a current measuring arrangement (12) is arranged, which is connected to an electronic control unit (13) of the protective switching device (1), wherein the electronic control unit (13) is designed to actuate the bypass switch (8) and the first semiconductor circuit arrangement (11) when a predeterminable overcurrent, in particular a short-circuit current, is detected by the current measuring arrangement (12), **characterised in that** the low-voltage protective switching device (1) has at least one voltage measuring arrangement (80) for detecting a Miller-effect-induced voltage peak at the at least one power semiconductor (21) of the first semiconductor circuit arrangement (11), that the voltage measuring arrangement (80) is connected to the electronic control unit (13), that the control unit (13) and/or the voltage measuring arrangement (80) is designed to detect - after output of a bypass switch opening signal - a predeterminable voltage peak that occurs, that the control unit (13) has a timer, which is started with the detection of the voltage peak, and that the control unit (13) is designed to output a switch-off signal to the first semiconductor circuit arrangement (11) upon expiry of the timer.

2. Low-voltage protective switching device (1) according to claim 1, **characterised in that** a first bypass diode (82) is connected between the control connection (81) of the power semiconductor (21) and a supply voltage connection (85).

3. Low-voltage protective switching device (1) according to claim 2, **characterised in that** the voltage measuring arrangement (80) is arranged in terms of circuitry parallel to the first bypass diode (82).

4. Low-voltage protective switching device (1) according to any one of claims 1 to 3, **characterised in that** two Zener diodes (86) arranged anti-serially are connected between the control connection (81) of the power semiconductor (21) and an earth connection (83) of the power semiconductor (21).

5. Low-voltage protective switching device (1) according to claim 4, **characterised in that** the voltage measuring arrangement (80) is arranged in terms of circuitry parallel to the two Zener diodes (86).

6. Low-voltage protective switching device (1) according to any one of claims 1 to 5, **characterised in that** a snubber (24) is connected parallel to the at least one power semiconductor (21).

## Revendications

1. Disjoncteur basse tension (1) avec au moins un chemin de conducteur extérieur (2) allant d'une borne d'alimentation de conducteur extérieur (3) du disjoncteur basse tension (1) à une borne de charge de conducteur extérieur (4) du disjoncteur basse tension (1), et un chemin de conducteur neutre (5) allant d'une borne de conducteur neutre (6) du disjoncteur basse tension (1) à une borne de charge de conducteur neutre (7) du disjoncteur basse tension (1), dans lequel un commutateur de dérivation (8) mécanique est agencé au sein du chemin de conducteur extérieur (2), dans lequel un premier agencement de circuit à semi-conducteurs (11) du disjoncteur basse tension (1) est couplé en parallèle au commutateur de dérivation (8), dans lequel le premier agencement de circuit à semi-conducteurs (11) présente au moins un semi-conducteur de puissance (21), en particulier un transistor bipolaire à grille isolée IGBT, avec une borne de commande, en particulier une borne de grille, dans lequel un agencement de mesure de courant (12) relié à une unité de commande électronique (13) du disjoncteur basse tension (1) est agencé au sein du chemin de conducteur extérieur (2), dans lequel l'unité de commande électronique (13) est conçue pour commander le commutateur de dérivation (8) et le premier agencement de circuit à semi-conducteurs (11) lors de la détection d'une surintensité pouvant être prédéfinie, en particulier d'un courant de court-circuit, grâce à l'agencement de mesure de courant (12), **caractérisé en ce que** le disjoncteur basse tension (1) présente au moins un agencement de mesure de tension (80) destiné à détecter un pic de tension, induit par l'effet Miller, au niveau du au moins un semi-conducteur de puissance (21) du premier agencement de circuit à semi-conducteurs (11), **en ce que** l'agencement de mesure de tension (80) est relié à l'unité de commande électronique (13), **en ce que** l'unité de commande (13) et/ou l'agencement de mesure de tension (80) est conçu(e)/sont conçus pour détecter un pic de tension pouvant être prédéfini et survenant après émission d'un signal d'ouverture de commutateur de dérivation, **en ce que** l'unité de commande (13) présente une minuterie qui est démarrée lors de la détection du pic de tension, et **en ce que** l'unité de commande (13) est conçue pour émettre un signal de coupure vers le premier agencement de circuit à semi-conducteurs (11) après expiration de la minuterie.

2. Disjoncteur basse tension (1) selon la revendication 1, **caractérisé en ce qu'**une première diode de dérivation (82) est commutée entre la borne de commande (81) du semi-conducteur de puissance (21) et une borne de tension d'alimentation (85).

3. Disjoncteur basse tension (1) selon la revendication 2, **caractérisé en ce que** l'agencement de mesure de tension (80) est agencé parallèlement à la première diode de dérivation (82) en termes de couplage électrique.

4. Disjoncteur basse tension (1) selon l'une quelconque des revendications 1 à 3, **caractérisé en ce que** deux diodes Zener (86) agencées de manière antisérielle sont commutées entre la borne de commande (81) du semi-conducteur de puissance (21) et une borne de masse (83) du semi-conducteur de puissance (21).

5. Disjoncteur basse tension (1) selon la revendication 4, **caractérisé en ce que** l'agencement de mesure de tension (80) est agencé parallèlement aux deux diodes Zener (86) en termes de couplage électrique.

6. Disjoncteur basse tension (1) selon l'une quelconque des revendications 1 à 5, **caractérisé en ce qu'**un suppresseur de surcharge (24) est commuté en parallèle au au moins un semi-conducteur de puissance (21).
